Europäisches Patentamt

European Patent Office

Office européen des brevets

(19)

(11) Veröffentlichungsnummer: **0 221 490**
A2

(12) # EUROPÄISCHE PATENTANMELDUNG

(21) Anmeldenummer: 86114901.1

(22) Anmeldetag: 27.10.86

(51) Int. Cl.⁴: **H 04 Q 3/52**
H 04 Q 11/04, H 03 K 19/094

(30) Priorität: 28.10.85 DE 3538319

(43) Veröffentlichungstag der Anmeldung:
13.05.87 Patentblatt 87/20

(84) Benannte Vertragsstaaten:
AT BE CH DE FR GB IT LI NL SE

(71) Anmelder: Siemens Aktiengesellschaft Berlin und
München
Wittelsbacherplatz 2
D-8000 München 2(DE)

(72) Erfinder: Hofmann, Rüdiger, Dr.
Fürstenfelder Weg 12
D-8031 Gilching(DE)

(54) Breitbandsignal-Raumkoppeleinrichtung.

(57) In einer Breitbandsignal-Raumkoppeleinrichtung sind die jeweils von einer decodergesteuerten, koppelpunktindividuellen Speicherzelle steuerbaren Koppelelemente jeweils mit einer zwischen Koppelelement-Eingang und Koppelelement-Ausgang liegenden C-MOS-Inverterschaltung mit MOS-Transistoren von Anreicherungstyp gebildet, bei der zwischen den p-Kanal-Anreicherungs-Transistor und die zugehörige Speisepotentialquelle ein weiterer p-Kanal-Transistor ebenfalls des Anreicherungstyps eingefügt ist und bei der zwischen den n-Kanal-Anreicherungs-Transistor und die zugehörige Speisepotentialquelle ein weiterer n-Kanal-Transistor ebenfalls des Anreicherungstyps eingefüt ist; die Steuerelektroden der genannten beiden weiteren Anreicherungs-Transistoren liegen an den Ausgängen der genannten Speicherzelle.

EP 0 221 490 A2

Siemens Aktiengesellschaft
Berlin und München

Breitbandsignal-Raumkoppeleinrichtung

Neuere Entwicklungen der Fernmeldetechnik führen zu diensteintegrierenden Nachrichtenübertragungs- u. -vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppenetzwerken für Breitband-Digitalsignale", Diss., Braunschweig 1978, Bild 6.7). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raum-

- 2a -

koppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als Koppelpunktmatrix ausgebildet sein, in deren Koppelpunkten die Koppelelemente jeweils von einer lediglich decodergesteuerten koppelpunktindividuellen Halte-Speicherzelle gesteuert werden (Pfannschmidt, a.a.O., Bild 6.4); die Koppelelemente können dabei jeweils als C-MOS-Transfergate (C-MOS-Transmissionsgate) ausgebildet sein (ISS'84 Conference Papers 23C1, Fig.9). Die Verwendung eines einfachen C-MOS-Transfergates als Koppelelement ist indessen bei dessen Durchschaltezustand mit einer Belastung seiner Eingangsleitung durch die Kapazität seiner Ausgangsleitung verbunden, was Signalverzögerungen mit sich bringen kann; außerdem kann es aufgrund von sog. Unterschwelleneffekten (z. B. in Form von Leckströmen oder Unterschwellenströmen) entlang der MOS-Transistoren zu Übersprecherscheinungen über an sich im Sperrzustand befindliche Koppelelemente hinweg kommen.

Entsprechendes gilt auch für eine Breitbandsignal-Raumkoppeleinrichtung mit Koppelpunkten mit jeweils von einer koppelpunktindividuellen Speicherzelle steuerbaren Koppelelementen, die jeweils mit einer eingangsseitig mit der zugehörigen Signal-Eingangsleitung verbundenen und ausgangsseitig zu der zugehörigen Signal-Ausgangsleitung führenden C-MOS-Inverterschaltung mit MOS-Transistoren vom Anreicherungstyp gebildet sind, zwischen deren p-Kanal-Anreicherungs-Transistor und die zugehörige Speisepotentialquelle ein mit seiner Steuerelektrode an den einen Ausgang der Speicherzelle angeschlossener p-Kanal-Verarmungs-Transistor eingefügt ist und zwischen deren n-Kanal-Anreicherungs-Transistor und die zugehörige Speisepotentialquelle ein mit seiner Steuerelektrode an den Komplementärausgang der Speicherzelle angeschlossener n-Kanal-Verarmungs-Transistor eingefügt ist (ISS'84 Conference Papers 31C3, Fig.14). Eine solche Ausbildung der Koppelelemente führt aufgrund einer ständigen zumindest schwachen Leitfähigkeit der beiden Verarmungs-Transistoren zu statischen Verlustleistungen des Koppelpunkts auch in dessen Sperrzustand sowie dazu, daß ein im Durchschaltezustand befindliches Koppelelement auch durch an sich im Sperrzustand befindliche, gleichwohl aber schwach leitfähige Koppelelemente belastet wird; des weiteren sind auch keine vollen Signalhübe zwischen den beiden Speisepotentialwerten möglich.

Die Erfindung stellt sich nun die Aufgabe, in einer Breitband-Raumkoppeleinrichtung einen Weg zu einer besonders zweckmäßigen Ausbildung der Koppelelemente aufzuzeigen, bei der die im vorstehenden angeführten Nachteile vermieden werden.

Die Erfindung betrifft eine Breitbandsignal-Raumkoppeleinrichtung mit Koppelpunkten mit jeweils von einer decodergesteuerten, koppelpunktindividuellen Speicherzelle steuerbaren Koppelelementen, die jeweils mit einer eingangsseitig mit der zugehörigen Signal-Eingangsleitung verbundenen und ausgangseitig zu der zugehörigen Signal-Ausgangsleitung führenden C-MOS-Inverterschaltung mit MOS-Transistoren vom Anreicherungstyp gebildet sind, zwischen deren MOS-Transistor des einen Kanaltyps und die zugehörige Speisepotentialquelle ein mit seiner Steuerelektrode an den einen Ausgang der Speicherzelle angeschlossener MOS-Transistor ebenfalls des einen Kanaltyps eingefügt ist und zwischen deren MOS-Transistor des anderen Kanaltyps und die zugehörige Speisepotentialquelle ein mit seiner Steuerelektrode an den Komplementärausgang der Speicherzelle angeschlossener MOS-Transistor ebenfalls des anderen Kanaltyps eingefügt ist; diese Breitbandsignal-Raumkoppeleinrichtung ist erfindungsgemäß dadurch

- 3 -

gekennzeichnet, daß zwischen den p-Kanal-Anreicherungs-Transistor und die zugehörige Speisepotentialquelle ein p-Kanal-Transistor ebenfalls des Anreicherungstyps eingefügt ist und zwischen den n-Kanal-Anreicherungs-Transistor und die zugehörige Speisepotentialquelle ein n-Kanal-Transistor ebenfalls des Anreicherungstyps eingefügt ist.

Die Erfindung bringt neben dem Vorteil einer vollständigen Entkopplung von Ausgangs- und Eingangsleitungen und der daraus resultierenden Eliminierung von Übersprechproblemen sowie einer Vermeidung von Verlustleistungen in im Sperrzustand befindlichen Koppelelementen den weiteren Vorteil einer hohen Arbeitsgeschwindigkeit mit sich, da zum einen Rückwirkungen der Ausgangsleitungskapazität auf die Eingangsleitung vermieden werden und zum anderen die Inverterschaltung, als Treiberpuffer für die Ausgangsleitung wirkend, die Flankensteilheit der durchgeschalteten Signale merklich vergrößert; zugleich können die Signale mit dem vollen Hub zwischen den beiden Speisepotentialwerten durchgeschaltet werden.

Weitere Besonderheiten der Erfindung werden aus der nachfolgenden näheren Erläuterung der Erfindung anhand der Zeichnung ersichtlich.

Dabei zeigen
FIG 1 schematisch ein Ausführungsbeispiel einer Breitbandkoppelanordnung und
FIG 2 Einzelheiten ihrer schaltungstechnischen Realisierung gemäß der Erfindung.

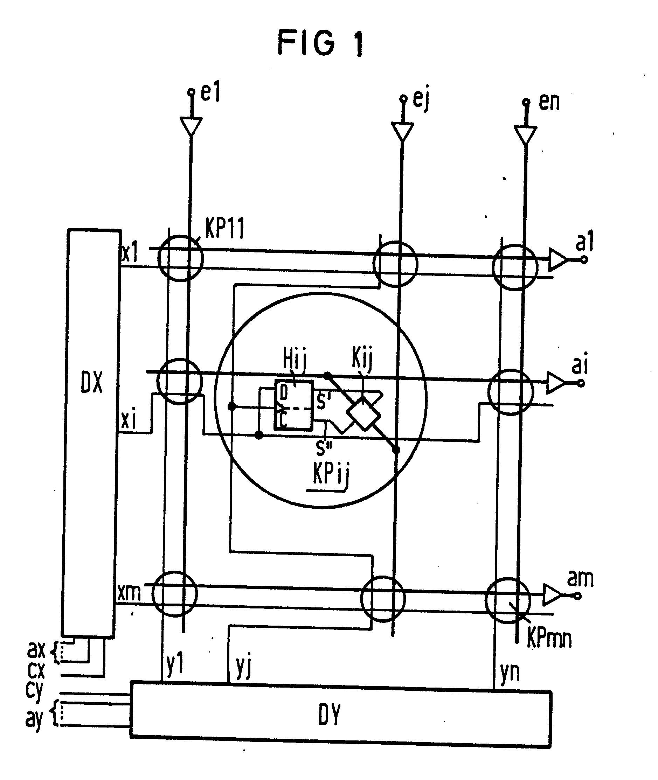

In der Zeichnung FIG 1 ist schematisch in einem zum Verständnis der Erfindung erforderlichen Umfange eine Breitbandsignal-Raumkoppeleinrichtung skizziert. Diese Raumkoppeleinrichtung weist eine Koppelpunktmatrix mit Koppelpunkten KP11...KPij... ...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert werden; diese Haltespeicherzelle Hij (beim Koppelpunkt KPij) ist durch ein bistabiles D-Kippglied gebildet, dessen beide Ausgänge s' und s" zu entsprechenden Steuereingängen des jeweiligen Koppelelements (Kij beim Koppelpunkt KPij) führen.

Die Halte-Speicherzellen ... Hij... werden ihrerseits durch zwei Ansteuerdecoder, nämlich einen Zeilendecoder DX und einen Spaltendecoder DY, über entsprechende Ansteuerleitungen x1...xi...xm; y1...yj...yn in zwei Koordinaten angesteuert; dabei ist der in Zeilenrichtung ansteuernde Decoder DX mit seinem jeweiligen Decoderausgang ...xi... an die D-Eingänge D der in der betreffenden Matrixzeile , im Beispiel in der i-ten-Zeile, angeordneten D-Kippglieder ...Hij... geführt, während der in Spaltenrichtung ansteuernde Decoder DY mit seinem jeweiligen Decoderausgang ...yj... an die Clock-Eingänge C der in der betreffenden Matrixspalte, beispielsweise in der j-ten Spalte, angeordneten D-Kippglieder ..Hij.. geführt ist.

Wie dies aus FIG 1 ersichtlich ist, mögen die beiden Ansteuerdecoder DX, DY über Eingangsleitungen ax, ay jeweils mit einer einer Matrixreihe (Zeile bzw. Spalte) von Koppelpunkten gemeinsamen Koppelpunktzeilen- bzw. Koppelpunktspalten-Adresse und über Eingangsleitungen cx, cy jeweils mit einem Adreßtaktsignal beaufschlagbar sein, auf die hin sie jeweils an der der jeweiligen Koppelpunktreihen-Adresse entsprechenden Ansteuerleitung zeitgerecht jeweils ein Ansteuersignal abgeben.

Das Zusammentreffen eines Zeilenansteuersignals und eines
Spaltenansteuersignals am Kreuzungspunkt der betreffenden
Matrixzeile mit der betreffenden Matrixspalte beim Aufbau
einer entsprechenden Verbindung bewirkt dann eine Aktivierung der dort befindlichen Halte-Speicherzelle, beispielsweise der Halte-Speicherzelle Hij, mit der Folge, daß das
von der betreffenden Halte-Speicherzelle (Hij) gesteuerte
Koppelelement, im Beispiel das Koppelelement Kij, leitend
wird.

Damit das im Beispiel betrachtete Koppelelement Kij bei
einem Abbau der betreffenden Verbindung wieder gesperrt
wird, genügt die Abgabe allein eines entsprechenden Spaltenansteuersignals durch den Spaltendecoder DY über dessen
Ansteuerleitung yj, ohne daß der Zeilendecoder DX über
seine Zeilenansteuerleitung xi ein Ansteuersignal abgibt;
das allein am Clock-Eingang C der zum Koppelpunkt Kpij
gehörenden Halte-Speicherzelle Hij auftretende Steuersignal
bewirkt dann die Rücksetzung der Halte-Speicherzelle Hij
mit der Folge, daß das von ihr gesteuerte Koppelelement Kij
gesperrt wird.

Die einzelnen Halte-Speicherzellen ...Hij... mögen jeweils
an ihrem einen Ausgang s' jeweils ein dem einen Speisepotential $U_{DD}$ (+5V) von C-MOS-Schaltungen entsprechendes
($U_{DD}$-)Signal oder ein dem anderen Speisepotential $U_{SS}$ (Masse)
von C-MOS-Schaltungen entsprechendes ($U_{SS}$-)Signal abgeben
und an ihrem anderen Ausgang s" das jeweils andere ($U_{SS}$-
bzw. $U_{DD}$-)Signal. Auf weitere Einzelheiten der schaltungstechnischen Realisierung der Halte-Speicherzellen ...Hij...
braucht hier nicht eingegangen zu werden, da dies zum
Verständnis der Erfindung nicht erforderlich ist; solche
Einzelheiten sind im übrigen bereits an anderer Stelle
(DE-P 35 33 915.2) angegeben.

- 6 -

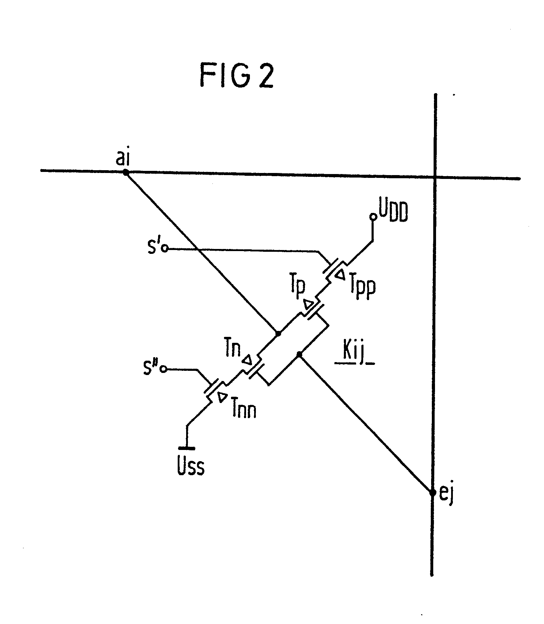

Einzelheiten der schaltungstechnischen Realisierung der Koppelelemente ...Kij... zeigt FIG 2. Gemäß FIG 2 ist ein solches Koppelelement Kij mit einer C-MOS-Inverterschaltung mit MOS-Transistoren Tp, Tn vom Anreicherungstyp gebildet, die eingangsseitig mit der zugehörigen Signal-Eingangsleitung ej verbunden ist und ausgangsseitig zu der zugehörigen Signal-Ausgangsleitung ai führt; die MOS-Anreicherungs-Transistoren sind in FIG 2 durch ein beispielsweise bei Weiß, Horninger: Integrierte MOS-Schaltungen, Springer-Verlag Berlin - Heidelberg - New York, 1982, und auch in den oben genannten ISS'84 Conference Papers 31C3 benutztes Schaltzeichen symbolisiert, wobei der jeweilige Kanaltyp durch einen dreieckigen Pfeil angezeigt wird. Zwischen den p-Kanal-Anreicherungs-Transistor Tp und die zugehörige Speisepotentialquelle $U_{DD}$ ist ein mit seiner Steuerelektrode an den Ausgang s' der Halte-Speicherzelle Hij (in FIG 1) angeschlossener p-Kanal-Transistor Tpp ebenfalls des Anreicherungstyps eingefügt, und zwischen den n-Kanal-Anreicherungs-Transistor Tn und die zugehörige Speisepotentialquelle $U_{SS}$ (Masse) ist ein mit seiner Steuerelektrode an den Komplementärausgang s" der Halte-Speicherzelle Hij (in FIG 1) angeschlossener n-Kanal-Transistor Tnn ebenfalls des Anreicherungstyps eingefügt.

Wenn von der Halte-Speicherzelle Hij (in FIG 1) her an den Steuereingang s' des Koppelelements Kij das $U_{SS}$-Potential angeschaltet ist und an den Steuereingang s" das $U_{DD}$-Potential, so ist das Koppelelement Kij im Durchschaltezustand; am Eingang ej auftretende Digitalsignale gelangen damit, im C-MOS-Inverter Tp,Tn invertiert und verstärkt, zum Ausgang ai, wobei durch den C-MOS-Inverter Tp,Tn zugleich eine Rückwirkung vom Ausgang ai auf den Eingang ej unterdrückt wird.

Wenn von der Halte-Speicherzelle Hij (in FIG 1) her an den Steuereingang s' des Koppelelements Kij das $U_{DD}$-Potential angeschaltet ist und an den Steuereingang s" das $U_{SS}$-Potential, so ist das Koppelelement Kij im Sperrzustand (Tristatezustand), so daß keine am Eingang ej auftretenden Signale zum Ausgang ai gelangen. Die C-MOS-Inverterschaltungen der im Sperrzustand (Tristate) befindlichen Koppelelemente der Koppelpunktmatrix KP11 ... KPij ... KPmn (in FIG 1) unterdrücken zugleich ein Übersprechen zwischen Ausgangsleitungen al...ai...am (in FIG 1) und Eingangsleitungen el...ej...en (in FIG 1) über solche gesperrte Koppelpunkte.

## <u>Bezugszeichenliste</u>                         85P1807

| | |
|---|---|
| a1,...ai,...an | Koppelpunktmatrix-Ausgangsleitungen |
| ax, cx; ay, cy | Decoder-Eingangsleitungen |
| C | Clock-Eingang des D-Kippgliedes |
| D | D-Eingang des D-Kippgliedes |
| DX | Zeilendecoder |
| DY | Spaltendecoder |
| e1,...ej,...en | Koppelpunktmatrix-Eingangsleitungen |
| Hij | Halte-Speicherzelle |
| Kij | Koppelelement |
| KP11,...KPij,...KPmn | Koppelpunkte |
| s', s" | Ausgänge des D-Kippglieds (der Halte-Speicherzelle), Steuereingänge des Koppelelements |
| Tp, Tn | C-MOS-Inverterschaltung |
| Tn | n-Kanal-Anreicherungs-Transistor |
| Tnn | "      "          "              " |
| Tp | p-    "          "              " |
| Tpp | "      "          "              " |
| x1,...xi,...xm | Zeilen-Decoderausgänge,-Ansteuerleitungen |
| y1,...yj,...yn | Spalten-    "              ,-         " |
| ej | C-MOS-Inverter-Eingang |
| ai | "     "        "      -Ausgang |
| $U_{DD}$, $U_{SS}$ | Speisepotentiale |

- 8 -

Patentanspruch

1. Breitbandsignal-Raumkoppeleinrichtung mit Koppelpunkten (KPij) mit jeweils von einer decodergesteuerten, koppelpunktindividuellen Speicherzelle (Hij) steuerbaren Koppelelementen (Kij), die jeweils mit einer eingangsseitig mit der zugehörigen Signal-Eingangsleitung (ej) verbundenen und ausgangsseitig zu der zugehörigen Signal-Ausgangsleitung (ai) führenden C-MOS-Inverterschaltung (Tp, Tn) mit MOS-Transistoren vom Anreicherungstyp gebildet sind,
zwischen deren MOS-Transistor (Tp) des einen Kanaltyps und die zugehörige Speisepotentialquelle ($U_{DD}$) ein mit seiner Steuerelektrode an den einen Ausgang (s') der Speicherzelle (Hij) angeschlossener MOS-Transistor (Tpp) ebenfalls des einen Kanaltyps eingefügt ist und
zwischen deren MOS-Transistor (Tn) des anderen Kanaltyps und die zugehörige Speisepotentialquelle ($U_{SS}$) ein mit seiner Steuerelektrode an den Komplementärausgang (s") der Speicherzelle (Hij) angeschlossener MOS-Transistor (Tnn) ebenfalls des anderen Kanaltyps eingefügt ist,
d a d u r c h   g e k e n n z e i c h n e t ,
daß zwischen den p-Kanal-Anreicherungs-Transistor (Tp) und die zugehörige Speisepotentialquelle ($U_{DD}$) ein p-Kanal-Transistor (Tpp) ebenfalls des Anreicherungstyps eingefügt ist und zwischen den n-Kanal-Anreicherungs-Transistor (Tn) und die zugehörige Speisepotentialquelle ($U_{SS}$) ein n-Kanal-Transistor (Tnn) ebenfalls des Anreicherungstyps eingefügt ist.

## FIG 1

FIG 2